# EUROPEAN PATENT APPLICATION

(11) **EP 2 717 662 A2**
(43) Date of publication of application: **09.04.2014**
(21) Application number: 11783008.3
(22) Date of filing: 26.05.2011
(51) Int. Cl.: H05K 7/20

(54) **STRAIGHT AIR RADIATION DEVICE AND COMMUNICATION DEVICE**

(71) Applicant: Huawei Technologies Co., Ltd., Shenzhen, Guangdong 518129 (CN)
(72) Inventor: WANG, Tao, Guangdong 518129 (CN); FENG, Taqing, Guangdong 518129 (CN)
(74) Representative: Isarpatent
(86) International application number: PCT/CN2011/074701
(87) International publication number: WO 2011/144091

(57) **Abstract**

A free cooling system apparatus applied to communication equipment includes: an air intake apparatus that is disposed at an air intake of the communication equipment, where the air intake apparatus includes an air intake duct, where the air intake duct has an opening below the air intake of the communication equipment to allow an airflow to enter the air intake duct through the opening, and a filtering module is disposed inside the air intake duct; and the filtering module includes a substrate and grass-like fibers, where the substrate is attached to a sidewall of the air intake duct, roots of the grass-like fibers are fixed onto the substrate, and tips of the grass-like fibers are suspended inside the air intake duct of the air intake apparatus and are transversely placed in the air intake duct along a direction of a cross section of the air intake duct.

## Description

### TECHNICAL FIELD

The present invention relates to the field of communications technologies, and in particular, to a free cooling system apparatus and a communication equipment.

### BACKGROUND

Heat of a communication equipment deteriorates equipment performance or even damages the equipment. To make the communication equipment work normally, it is necessary to solve the problem of heat dissipation of the communication equipment and ensure that an ambient temperature in which the communication equipment stays is within an allowed range.

There are three common heat dissipation solutions: air conditioning, heat exchanger, and free cooling. The air conditioner and the heat exchanger consume much energy and have a large size, poor reliability, and poor maintainability. In the free cooling, outdoor fresh air is used to dissipate heat of the communication equipment directly, which makes the equipment work in a good environment and has a significant energy saving effect; in addition, a free cooling system apparatus has a small size, meets a trend of product downsizing, and is highly reliable and maintainable.

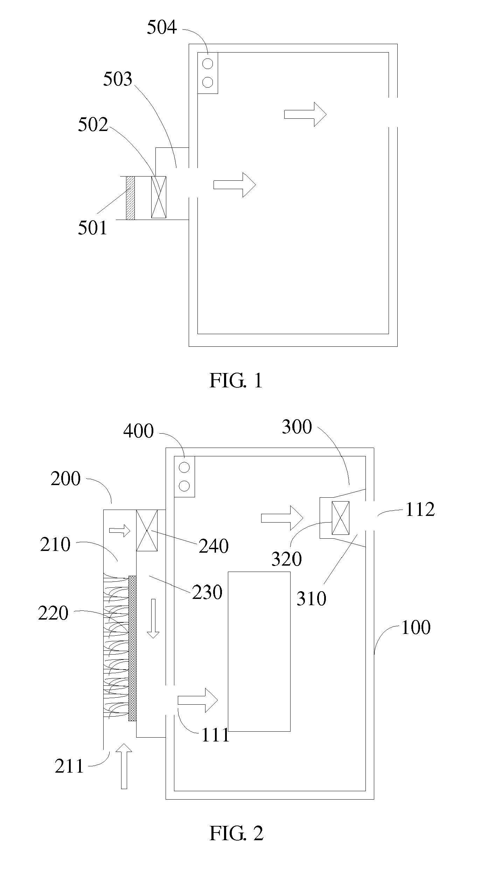

Currently, as shown in FIG. 1, an ordinary free cooling system apparatus mainly includes a filter screen 501, a fan 502, a labyrinth air duct 503, and a control panel 504. As driven by the fan, an airflow is filtered by the filter screen, enters the communication equipment through the labyrinth air duct, and finally flows out of an air exhaust to expel heat. The control panel may be configured to control a rotation speed of the fan and report a fault. The ordinary free cooling system apparatus has a low filtering efficiency, which is generally lower than 50%, and a short maintenance cycle, which is generally 3 to 6 months. Therefore, the reliability of the communication equipment is reduced, and frequent maintenance makes the maintenance cost high.

To improve the filtering efficiency, an air-ventilated film is used to replace the filter screen in the prior art. The air-ventilated film brings a high filtering efficiency, but the resistance of the air-ventilated film increases along with the increase of wind force, causing a significant air resistance effect. In a windy and dusty area, the air-ventilated film may be clogged with dust and need maintenance before long, which leads to a very short maintenance cycle.

The foregoing existing free cooling system apparatus has a short maintenance cycle and needs frequent maintenance and a high maintenance cost.

### SUMMARY

Embodiments of the present invention provide a free cooling system apparatus and a communication equipment.

A free cooling system apparatus, applied to a communication equipment, includes:
an air intake apparatus that is disposed at an air intake of the communication equipment, where
the air intake apparatus includes an air intake duct that is disposed along a direction of gravity or at an acute angle against the direction of gravity, where the air intake duct has an opening below the air intake of the communication equipment to allow an airflow to enter the air intake duct through the opening, and a filtering module is disposed inside the air intake duct; and
the filtering module includes a substrate and grass-like fibers, where the substrate is attached to a sidewall of the air intake duct, roots of the grass-like fibers are fixed onto the substrate, and tips of the grass-like fibers are suspended inside the air intake duct of the air intake apparatus and are transversely placed in the air intake duct along a direction of a cross section of the air intake duct.

A communication equipment includes:
an enclosure, an equipment body disposed inside the enclosure, and the free cooling system apparatus described above disposed outside the enclosure, where the enclosure has an air intake and an air exhaust, and an air intake apparatus of the free cooling system apparatus is disposed at the air intake.

In the free cooling system apparatus provided in the embodiments of the present invention, an air intake duct is disposed along a direction of gravity approximately, an opening used to allow entry of an airflow is below an air intake of a communication equipment, grass-like fibers disposed in a filtering module in the air intake duct are suspended in the air intake duct and transversely placed in the air intake duct along a direction of a cross section, and can swing freely as actuated by an incoming airflow. In this way, when an airflow enters the air intake duct from bottom to top, dust and impurities in the airflow are obstructed and filtered by the grass-like fibers layer by layer. The filtered dust and impurities subside naturally due to the swing of the grass-like fibers and finally fall down through the opening of the air intake duct. In this way, the free cooling system apparatus provided in the embodiments of the present invention has an automatic dust suppression function, and can be maintenance-free or prolong the maintenance cycle, thereby reducing the maintenance cost.

### BRIEF DESCRIPTION OF DRAWINGS

FIG. 1 is a schematic structural diagram of a free cooling system apparatus in the prior art;
FIG. 2 is a schematic diagram of a free cooling system apparatus according to an embodiment of the present invention;
FIG. 3 is a schematic diagram of a filtering module according to an embodiment of the present invention; and
FIG. 4 is a schematic diagram of a free cooling system apparatus according to another embodiment of the present invention.

### DESCRIPTION OF EMBODIMENTS

Embodiments of the present invention provide a free cooling system apparatus. The apparatus has an automatic dust suppression function, and can be maintenance-free or prolong the maintenance cycle, thereby reducing the maintenance cost. The embodiments of the present invention further provide a communication equipment that uses the free cooling system apparatus. Detailed descriptions are provided below.

Referring to FIG. 2, an embodiment of the present invention provides a free cooling system apparatus, which is installed on a communication equipment 100 for dissipating heat of the communication equipment 100. Generally, the communication equipment 100 has at least one air intake 111 and at least one air exhaust 112. The free cooling system apparatus provided in this embodiment includes at least one air intake apparatus 200 that is disposed at an air intake 111 of the communication equipment 100. An outside natural wind (or called an airflow) passes through the air intake apparatus 200 with dust being filtered out, enters the communication equipment 100 from the air intake 111, and then carries interior heat of the communication equipment 100 and flows out of the air exhaust 112, to achieve a heat dissipation function. For the flow direction of the airflow, refer to a directions indicated by arrows in the accompanying drawing.

The air intake apparatus 200 includes an air intake duct 210 that is disposed along a direction of gravity or at an acute angle against the direction of gravity, where the air intake duct 210 has an opening 211 below the air intake 111 of the communication equipment 100 to allow an airflow to enter the air intake duct 210 through the opening 211, and a filtering module 220 is disposed inside the air intake duct 210. Because the opening 211 is located below the air intake 211, an outside airflow enters the opening 211 and flows from bottom to top along the air intake duct 210, and is filtered by the filtering module 220 and then arrives at the air intake 111 of the communication equipment 100. The air intake duct 210 may be disposed vertically along the direction of gravity, that is, perpendicular to the horizon; and may also be disposed at an acute angle against the direction of gravity, which is preferably an angle of less than 30 degrees.

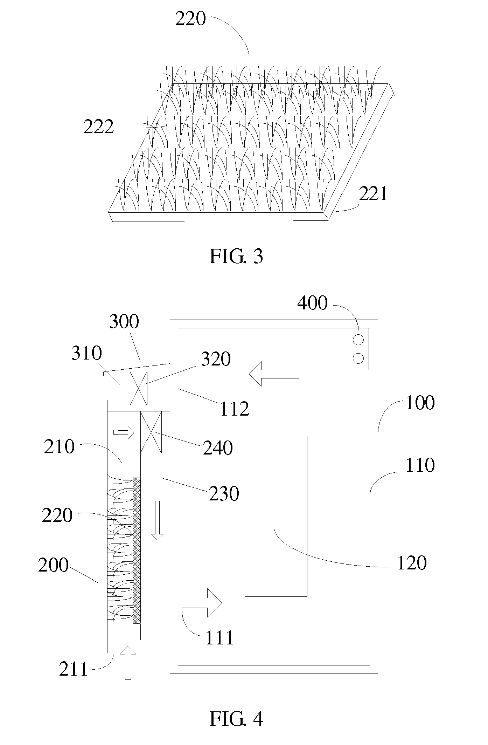

As shown in FIG. 3, the filtering module 220 includes a substrate 221 and grass-like fibers 222, where the substrate 221 is attached to a sidewall of the air intake duct 210, roots of the grass-like fibers 222 are fixed onto the substrate 221, and tips of the grass-like fibers 222 are suspended inside the air intake duct 210 of the air intake apparatus 200 and are transversely placed in the air intake duct 210 along a direction of a cross section of the air intake duct 210. The filtering module 220 is similar to a fabricated lawn, and it may be deemed that a fabricated lawn is affixed to the sidewall of the air intake duct 210, where the tips of the grass-like fibers 222 reach an opposite sidewall to completely cover the entire cross section of the air intake duct 210.

The principle of the filtering apparatus in this embodiment is similar to aquatic grasses filtering river water. Multiple clusters of grass-like fibers 222 arranged evenly or unevenly are fixed onto the substrate 221. When an airflow passes through a grass-like fiber clump formed by the multiple clusters of grass-like fibers 222, dust and impurities carried in the airflow are obstructed and filtered out by the grass-like fibers 222 which swing with the wind. Because the opening 211 of the air intake duct 210 is below the air intake 111 and the airflow flows from bottom to top, the obstructed dust and impurities constantly subside naturally due to constant swing of the grass-like fibers 222 with the wind, and finally fall down from the opening 211 of the air intake duct 210. In this way, the free cooling system apparatus in this embodiment has an automatic dust suppression function, and is not only free from clogging with dust but also does not need periodical manual maintenance for dust removal, and can be maintenance-free or prolong the maintenance cycle, thereby reducing the maintenance cost.

In addition, the filtering apparatus mainly formed of grass-like fibers provided in the embodiment of the present invention is a stereoscopic structure, and provides a certain filtering depth from bottom to top, which may be regarded as stereoscopic filtering. By contrast, a filter screen or an air-ventilated film in the prior art is constructed of only one layer, and may be called planar filtering. The stereoscopic filtering in this embodiment has higher filtering efficiency than that of the planar filtering, and is free from clogging with dust.

In addition, the filtering apparatus provided in the embodiment of the present invention is of a structure with a sound absorption effect, and can reduce noise.

The following describes the filtering module 220 in further detail.

As shown in FIG. 3, in the filtering module 220, the substrate 221 may be made of various materials such as a mesh cloth or woven cloth or composite fiber cloth, where multiple woven holes are distributed evenly or unevenly on the substrate. Several grass-like fibers 222 gather into one cluster, and each cluster of grass-like fibers 222 is fixed in one woven hole. Roots of a cluster of grass-like fibers 222 may be fixed into one woven hole with glue. The grass-like fibers 222 may be grass leaf-like fibers made of various materials such as fibers of polypropylene, polyvinyl chloride or polyamide. The length of the grass-like fibers 222 is preferably not smaller than the width of the air intake duct 210, so that when the roots of the grass-like fibers 222 are fixed to a sidewall of the air intake duct 210 through the substrate 221, the tips of the grass-like fibers 222 can reach the opposite sidewall to obstruct the entire air intake duct. The filtering module 220 features a large dust-tolerant rate and a low resistance coefficient.

The filtering module 220 may include only one substrate 221 onto which multiple clusters of grass-like fibers 222 are fixed, where the substrate 221 is fixed to only one sidewall of the air intake duct 210; or may include multiple substrates 221 onto which multiple clusters of grass-like fibers 222 are fixed, where the substrates 221 are fixed to multiple sidewalls of the air intake duct 210 separately, so as to better obstruct the air intake duct 220 and improve the filtering efficiency.

In this embodiment, the materials of the substrate 221 and the grass-like fibers 222 in the filtering module 220 are not limited, and the sizes of the substrate 221 and the grass-like fibers 222 are not limited, as long as the sizes fit the air intake duct 220. For example, the substrate 221 may be in a rectangle with a length being about 400 mm and a width being about 450 mm; the grass-like fibers 222 may be in a column shape or a bar shape or other shapes with a length being not less than 10 mm and a diameter being not less than 1 mm. In an implementation manner, the length of the grass-like fibers 222 may be 50 mm; in this case, the thickness of the filtering module 220 is slightly greater than 50 mm.

In an embodiment, in order to make the dust and impurities filtered out by the filtering module 220 better subside naturally to prolong the maintenance cycle, dustproof treatment (also known as dust-resistance treatment) may be performed on the grass-like fibers 222, to make the grass-like fibers 222 dust-free. For example, a layer of nanometer materials may be disposed on surfaces of the grass-like fibers 222, or the grass-like fibers 222 are entirely made of nanometer materials, so as to achieve a better dust-resistance effect.

In an embodiment, as shown in FIG. 2, the air intake apparatus 200 further includes a connection duct 230; one end of the connection duct 230 is connected to the air intake duct 210, and the other end is connected to the air intake 111 of the communication equipment 100; an intake fan 240 is disposed in the connection duct 230. Under the effect of the intake fan 240, outside air may pass through the air intake duct 210 and the connection duct 230 successively, and flows into the communication equipment 100. The connection duct 230 may be a straight duct, or may be a bent duct. By using the connection duct 230, the air intake apparatus 200 may have a noise reduction effect.

In an embodiment, as shown in FIG. 2, to speed up an airflow and improve a heat dissipation effect, the free cooling system apparatus may further include one air exhaust apparatus 300. The air exhaust apparatus 300 includes an air exhaust duct 310 connected to an air exhaust 112 of the communication equipment 100, and an exhaust fan 320 disposed inside the air exhaust duct 310. Under the effect of the exhaust fan 320, air inside the communication equipment 100 may be expelled more quickly, thereby carrying away the interior heat of the communication equipment 100 more quickly.

The intake fan 240 and the exhaust fan 320 may be powered by an external power supply, or may be powered by using a power supply inside the communication equipment 100. A control panel 400 including control buttons of the intake fan 240 and the exhaust fan 320 may be fixed inside or outside the communication equipment, for operation by management and maintenance personnel.

As shown in FIG. 2 and FIG. 4, locations for assembling the air intake apparatus 200 and the air exhaust apparatus 300 on the communication equipment depend on locations of the air intake 111 and the air exhaust 112, and the air intake apparatus 200 and the air exhaust apparatus 300 may be disposed on the same side of the communication equipment, and may also be disposed on opposite sides, or disposed in other manners. The air exhaust apparatus 300 may be disposed inside the communication equipment 100, and may also be disposed outside the communication equipment 100.

In conclusion, the free cooling system apparatus provided in the embodiment of the present invention uses a filtering module which is mainly formed of grass-like fibers and features a large dust-tolerant rate and a low resistance coefficient, and with an air intake duct that is disposed along a direction of gravity and has an opening at a lower end, the free cooling system apparatus has a very high filtering efficiency, and brings an effect of automatic dust suppression, which can be maintenance-free or prolong the maintenance cycle, thereby reducing the maintenance cost. If dustproof treatment is performed on the grass-like fibers, the effect of automatic dust suppression will be better.

As shown in FIG. 4, an embodiment of the present invention further provides a communication equipment 100, including:
an enclosure 110, an equipment body 120 disposed inside the enclosure, and the free cooling system apparatus described in the preceding embodiment disposed outside the enclosure 110, where the enclosure has an air intake 111 and an air exhaust 112, and an air intake apparatus 200 of the free cooling system apparatus is disposed at the air intake 111.

Specifically, the communication equipment 100 may be a communication cabinet. The free cooling system apparatus may be separated from the communication cabinet, and connected to an enclosure of the communication cabinet in a manner of screw connection or the like. The free cooling system apparatus and the enclosure of the communication cabinet may also form an integrated structure.

The communication equipment may be a communication equipment of another type such as an outdoor cabinet, an outdoor equipment room, or an outdoor mini-shelter (Mini-shelter).

It should be noted that the free cooling system apparatus in the embodiment of the present invention is applicable to not only the communication equipment, but also any equipment that needs heat dissipation.

The free cooling system apparatus and the communication equipment provided in the embodiments of the present invention are introduced in detail above. Specific examples are used for illustration of the principles and implementation manners of the present invention. The description of the foregoing examples is merely used to help understand the method and core ideas of the present invention, and shall not be construed as a limitation to the present invention.

## Claims

1. A free cooling system apparatus, applied to a communication equipment, comprising:
an air intake apparatus that is disposed at an air intake of the communication equipment, wherein
the air intake apparatus comprises an air intake duct that is disposed along a direction of gravity or at an acute angle against the direction of gravity, wherein the air intake duct has an opening below the air intake of the communication equipment to allow an airflow to enter the air intake duct through the opening, and a filtering module is disposed inside the air intake duct; and
the filtering module comprises a substrate and grass-like fibers, wherein the substrate is attached to a sidewall of the air intake duct, roots of the grass-like fibers are fixed onto the substrate, and tips of the grass-like fibers are suspended inside the air intake duct of the air intake apparatus and are transversely placed in the air intake duct along a direction of a cross section of the air intake duct.

2. The apparatus according to claim 1, wherein:
dustproof treatment is performed on surfaces of the grass-like fibers.

3. The apparatus according to claim 2, wherein:
nanometer materials are disposed on the surfaces of the grass-like fibers, or the grass-like fibers are entirely made of nanometer materials.

4. The apparatus according to claim 1, wherein:
the grass-like fibers are in a column shape or a bar shape with a length being greater than 10 mm and a diameter being greater than 1 mm.

5. The apparatus according to claim 1, wherein:
the air intake apparatus further comprises a connection duct; two ends of the connection duct are connected to the air intake duct and the air intake of the communication equipment respectively; an intake fan is disposed in the connection duct.

6. The apparatus according to claim 1, further comprising an air exhaust apparatus, wherein:
the air exhaust apparatus comprises an air exhaust duct connected to an air exhaust of the communication equipment, and an exhaust fan disposed inside the air exhaust duct.

7. A communication equipment, comprising:
an enclosure, an equipment body disposed inside the enclosure, and the free cooling system apparatus according to any one of claims 1 to 6 disposed outside the enclosure, wherein the enclosure has an air intake and an air exhaust, and an air intake apparatus of the free cooling system apparatus is disposed at the air intake.

8. The communication equipment according to claim 7, wherein:
the free cooling system apparatus and the enclosure form an integrated structure.
